# EUROPEAN PATENT APPLICATION

(11) **EP 4 207 193 A1**
(43) Date of publication of application: **05.07.2023**
(21) Application number: 21859978.5
(22) Date of filing: 20.07.2021
(51) Int. Cl.: G10L 21/0216, G10L 19/26, H04N 5/225

(54) **AUDIO PROCESSING SYSTEM AND NETWORK CAMERA**

(30) Priority: 31.08.2020 CN 202021862079 U
(71) Applicant: Hangzhou Hikvision Digital Technology Co., Ltd., Hangzhou, Zhejiang 310051 (CN)
(72) Inventor: LIANG, Yanwu, Hangzhou, Zhejiang 310051 (CN); SUN, Wangdeng, Hangzhou, Zhejiang 310051 (CN); JIN, Qingtian, Hangzhou, Zhejiang 310051 (CN)
(74) Representative: BRP Renaud & Partner mbB Rechtsanwälte Patentanwälte Steuerberater
(86) International application number: PCT/CN2021/107417
(87) International publication number: WO 2022/042138

(57) **Abstract**

The present disclosure provides an audio processing system and a network camera. The system includes a protective device, a first filtering device and a second filtering device which are connected in sequence, wherein, the protective device includes a protector connected to an audio input and output device and configured for reducing the electrostatic voltage in an inputted or outputted audio signal to a preset value; the first filtering device includes a common-mode filtering module and a differential-mode filtering module, wherein the common-mode filtering module is connected to the protector and is configured for consuming noise energy in the audio signal and filtering common-mode interference; the differential-mode filtering module is connected to the common-mode filtering module and is configured for filtering differential-mode interference. Based on this, the noise anti-interference problem of various tests is solved based on a concise protective filtering circuit by reasonably matching the ways of 'blocking' and 'draining' noise energy.

## Description

The present application claims the priority to a Chinese patent application No. 202021862079.6 filed with the China National Intellectual Property Administration on August 31, 2020 and entitled "Audio processing system and network camera", which is incorporated herein by reference in its entirety.

### Technical field

The present disclosure relates to the technical field of computers, in particular to an audio processing system and a network camera.

### Background

With the popularity of smart devices, the smart devices will be used in more and more scenes. However, these devices inevitably bring noise interference while facilitating human beings. The noise interference makes the electromagnetic environment of the scene very bad, which further affects the performance of the smart devices, which poses a higher challenge to the anti-interference capability of smart devices.

The current anti-interference solution is that, generally, all audio signals are passed through differential lines and are isolated and protected at the beginning of PCB design, but the effect is not obvious. Therefore, there is a need to provide a more effective audio processing solution.

### Summary

The embodiment of the present disclosure provides an audio processing system to improve the compatibility of noise anti-interference problems.

An audio processing system provided by an embodiment of the present disclosure includes:
a protective device, a first filtering device and a second filtering device which are connected in sequence, wherein:
the protective device includes a protector connected to an audio input and output device and configured for reducing the electrostatic voltage in an inputted or outputted audio signal to a preset value;
the first filtering device includes a common-mode filtering module and a differential-mode filtering module, wherein the common-mode filtering module is connected to the protector and is configured for consuming noise energy in the audio signal and filtering common-mode interference; the differential-mode filtering module is connected to the common-mode filtering module and is configured for filtering differential-mode interference;
the second filtering device includes a low-pass filter, wherein the low-pass filter is connected to the differential-mode filtering module and configured for high-frequency noise filtering of the audio signal.

In some embodiments, the protector includes a transient suppressor, wherein one end of the transient suppressor is connected to a positive terminal of the audio input and output device, and the other end of the transient suppressor is connected to a negative terminal of the audio input and output device.

In some embodiments, the common-mode filtering module includes a first capacitor, a second capacitor and a common-mode inductor, wherein:
the first capacitor and the second capacitor are sequentially connected in parallel with the protector and grounded through a resistor for consuming noise energy in the audio signal;
the common-mode inductor is arranged between the second capacitor and the differential-mode filtering module for filtering common-mode interference.

In some embodiments, the differential-mode filtering module includes a third capacitor and a fourth capacitor, wherein:
the third capacitor and the fourth capacitor are sequentially connected to the common-mode filtering module and grounded for filtering differential-mode interference.

In some embodiments, the first capacitor and the second capacitor are connected to a primary ground GND, and the third capacitor and the fourth capacitor are connected to a secondary ground AGND.

In some embodiments, the low-pass filter includes a first resistor, a fifth capacitor, a second resistor and a sixth capacitor, wherein:
one end of the first resistor is connected to the differential-mode filtering module, and the other end of the first resistor is connected to one end of the fifth capacitor, and the other end of the fifth capacitor is grounded;
one end of the second capacitor is connected to the common end of the first resistor and the fifth capacitor, and the other end of the second capacitor is connected to one end of the sixth capacitor, and the other end of the sixth capacitor is grounded.

In some embodiments, the second filtering device further includes a high-frequency filter;
wherein the high-frequency filter includes a first magnetic bead connected to the low-pass filter and configured for secondary high-frequency noise filtering of the audio signal, and the noise frequency filtered by the high-frequency filter is greater than the noise frequency filtered by the low-pass filter.

In some embodiments, the audio processing system further includes a third filtering device;
the third filtering device includes a second magnetic bead, the second magnetic bead is arranged between an operational amplifier circuit and a power supply of the operational amplifier circuit and configured for filtering power supply noise;
wherein, the operational amplifier circuit is connected to the high-frequency filter for restoring an amplitude of an audio signal outputted by the high-frequency filter.

In some embodiments, the third filtering device further includes a third magnetic bead, and the third magnetic bead is arranged between a Codec and a power supply of the Codec and configured for filtering power supply noise;
wherein, the Codec is connected to the operational amplifier circuit for processing an audio signal outputted by the operational amplifier circuit.

The embodiment of the present disclosure also provides an audio processing system, including a left channel subsystem and a right channel subsystem of the above system.

The embodiment of the present disclosure also provides a network camera, including: an audio input and output device, the above-mentioned audio processing system and a Codec connected in sequence, wherein:
the audio input and output device is configured for inputting an audio signal acquired by a sound acquisition device to the audio processing system, or, outputting an audio signal outputted by the audio processing system to a sound playing device;
the Codec is configured for encoding and decoding the audio signal outputted by the audio processing system and transmitting it to external equipment via a network; or, encoding and decoding an audio signal inputted by the external equipment and inputting it to the audio processing system.

An embodiment of the present disclosure realizes that the problem of noise interference is solved based on a concise protective filtering circuit by reasonably matching the ways of 'blocking' and 'draining' noise energy.

### Brief Description of the Drawings

In order to illustrate the technical solutions of the embodiments and the prior art of the present invention more clearly, the following is a brief description of the drawings needed in the embodiments and the prior art that need to be used. Obviously, the drawings in the following description are only some embodiments of the present invention, and other embodiments can be obtained according to these drawings without creative efforts for ordinary skilled in the art.
Fig. 1 is a schematic diagram of the structure of an audio processing system provided by an embodiment of the present disclosure;
Fig. 2 is a schematic diagram of the circuit structure of an audio processing system provided by an embodiment of the present disclosure;
Fig. 3 is a schematic diagram of the effect of a protector provided by an embodiment of the present disclosure;
Fig. 4 is a schematic diagram of the effect of the first filtering device provided by an embodiment of the present disclosure;
Fig. 5a is a schematic diagram of the effect of the second filtering device provided by an embodiment of the present disclosure;
Fig. 5b is a schematic diagram of the effect of ETF tests provided by an embodiment of the present disclosure;
Fig. 6 is a schematic diagram of the structure of an audio processing system provided by another embodiment of the present disclosure;
Fig. 7 is a schematic diagram of the structure of an audio processing system provided by yet an embodiment of the present disclosure;
Fig. 8 is a schematic diagram of the structure of a network camera provided by an embodiment of the present disclosure.

The description of each reference sign in the figures is as follows:
100- protective device;
200- first filtering device;
210- common-mode filtering module, C1- first capacitor, C2- second capacitor, L- common-mode inductor;
220- differential-mode filtering module, C3- third capacitor, C4- fourth capacitor;
300- second filtering device;
310- low-pass filter, R1- first resistor, C5- fifth capacitor, R2- second resistor, C6- sixth capacitor;
FB1- first magnetic bead, FB2- second magnetic bead, FB3- third magnetic bead;
610- protective filtering circuit, 620- operational amplifier circuit, 630- Codec;
710- first module, 720- second module, 730- third module, 740- fourth module.

### Detailed Description

In order to make the purpose, technical solutions and advantages of the invention more clear, the invention will be further described in detail with reference to the accompanying drawings and embodiments. Obviously, the described embodiments are only a part of the embodiments of the present invention, not all of them. Based on the embodiments in the present invention, all other embodiments obtained by ordinary skilled in the art without creative efforts fall within the scope of protection of the present invention.

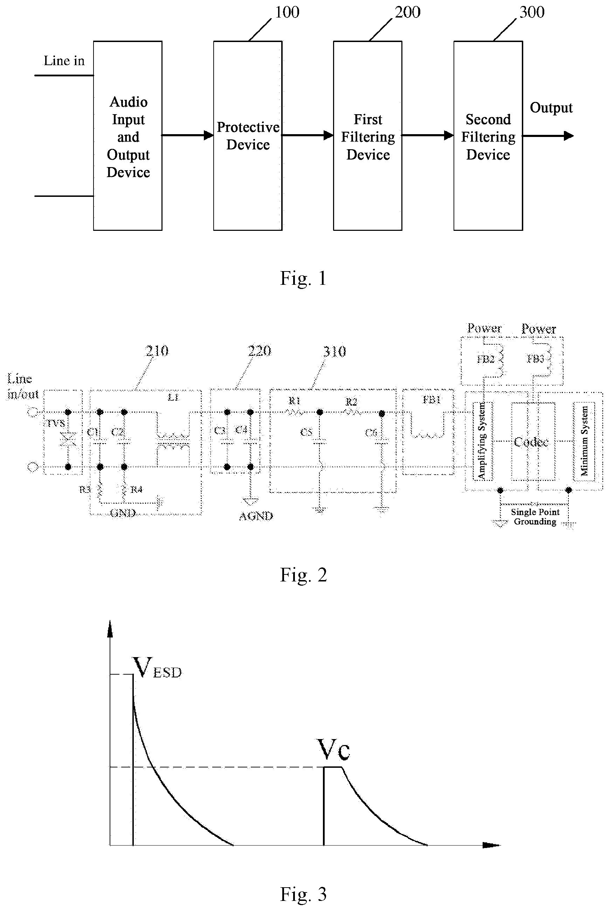

Fig. 1 is a schematic diagram of the structure of an audio processing system provided by an embodiment of the present disclosure. Referring to Fig. 1, the system may specifically include a protective device 100, a first filtering device 200 and a second filtering device 300 which are connected in sequence, wherein:
the protective device 100 includes a protector connected to an audio input and output device and configured for reducing the electrostatic voltage in an inputted or outputted audio signal to a preset value;
referring to Fig. 2, the first filtering device 200 includes a common-mode filtering module 210 and a differential-mode filtering module 220, wherein the common-mode filtering module 210 is connected to the protector and configured for consuming noise energy in the audio signal and filtering common-mode interference; the differential-mode filtering module 220 is connected to the common-mode filtering module 210 and configured for filtering differential-mode interference;
the second filtering device 300 includes a low-pass filter 310 connected to the differential-mode filtering module 220 and configured for high-frequency noise filtering of the audio signal.

The structure of the circuit of the protective device 100, the first filtering device 200 and the second filtering device 300 is described in detail with reference to Fig. 2, taking a single channel as an example.

### 1) In regard to the protective device 100

The protective device 100 may include a transient suppressor TVS, wherein one end of the transient suppressor is connected to the positive terminal of the audio input and output device, and the other end is connected to the negative terminal of the audio input and output device.

Based on this, in combination with Fig. 3, when there is electrostatic VESD in the audio signal, the peak voltage thereof can be reduced to the preset value Vc through TVS, thus achieving the purpose of protecting the subsequent circuit. Wherein, TVS can be preferably a two-way TVS with a voltage of about 15V to ensure the effect of voltage reduction.

### 2) In regard to the first filtering device 200

The common-mode filtering module 210 of the first filtering device 200 includes a first capacitor C1, a second capacitor C2 and a common-mode inductor L, wherein:
the first capacitor C1 and the second capacitor C2 are sequentially connected in parallel with the protector and grounded through a resistor for consuming the noise energy in the audio signal; Specifically, the first capacitor C1 is grounded via the third resistor, and the second capacitor C2 is grounded via the fourth capacitor C4. Of course, both can also be grounded via the same resistor;
the common-mode inductor L is arranged between the second capacitor C2 and the differential-mode filtering module 220 for filtering common-mode interference.

The differential-mode filtering module 220 of the first filtering device 200 includes a third capacitor C3 and a fourth capacitor C4, wherein:
the third capacitor C3 and the fourth capacitor C4 are sequentially connected to the common-mode filtering module 210 and grounded for filtering differential-mode interference.

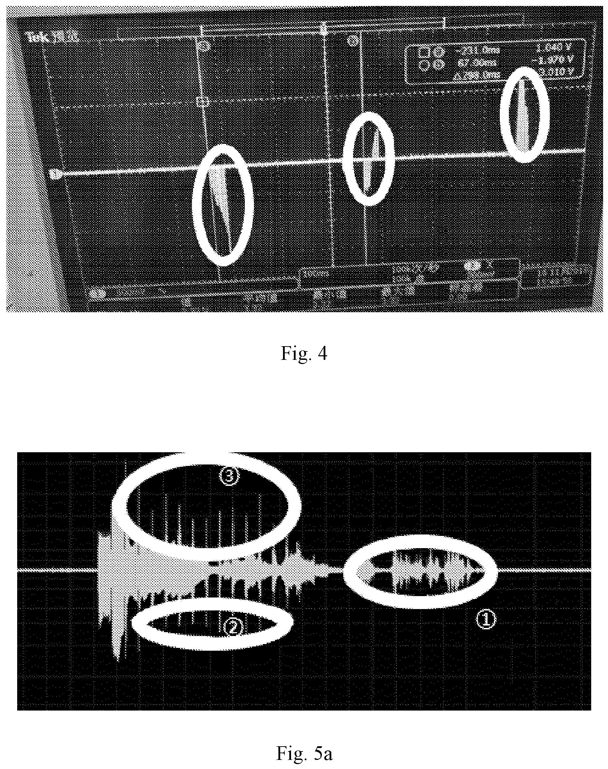

Based on this, in combination with Fig. 4, when the audio signal is coupled with the illustrated noise (such as the sound signal in the white ellipse), the noise can be filtered through the common-mode filtering module 210 and the differential-mode filtering module 220, and normal sound signal is retained. The first capacitor C1 to the fourth capacitor C4 are preferably nF-class capacitors, and the common-mode inductor L needs to maintain a high impedance, preferably greater than 1000 ohms, within the range of 10-1000MHZ, to ensure the filtering effect.

Further, the first capacitor C1 and the second capacitor C2 can be set to connect to the primary ground GND, and the third capacitor C3 and the fourth capacitor C4 can be set to connect to the secondary ground AGND. Therefore, AGND can be guaranteed to be free from external interference, and making the audio signal more "clean".

### 3) In regard to the second filtering device 300

The low-pass filter 310 of the second filtering device 300 includes a first resistor R1, a fifth capacitor C5, a second resistor R2 and a sixth capacitor C6, wherein:
one end of the first resistor R1 is connected to (the common-mode inductor L of) the differential-mode filtering module 220, and the other end of the first resistor R1 is connected to one end of the fifth capacitor C5, and the other end of the fifth capacitor C5 is grounded;
one end of the second capacitor C2 is connected to the common end of the first resistor R1 and the fifth capacitor C5, and the other end of the second capacitor C2 is connected to one end of the sixth capacitor C6, and the other end of the sixth capacitor C6 is grounded.

Based on this, in combination with Fig. 5a, when the audio signal is coupled with the illustrated noise (such as sound signals in white ellipses ② and ③, the noise can be filtered through the low-pass filter 310, and normal sound signals (such as sound signals in white ellipses ① are retained. Wherein the cut-off frequency of the low-pass filter 310 is about 2MHZ.

In addition, in order to avoid the case that the noise frequency is too high which leads to incomplete filtering, a high-frequency filter aiming at this case can be added to the second filtering device 300. In combination with Fig. 2, the high-frequency filter includes a first magnetic bead FB1 connected to the low-pass filter 310, which is configured for secondary high-frequency noise filtering of the audio signal, and the noise frequency filtered by the high-frequency filter is greater than the noise frequency filtered by the low-pass filter 310. Wherein, the first magnetic bead FB 1 needs to maintain a high impedance, preferably greater than 600 ohms, in the range of 20-3000 MHz, and the inductive reactance X in this frequency band needs to be less than the resistance of the resistor R.

Combining the above common-mode filtering module 210 and the above differential-mode filtering module 220, in this embodiment, the noise energy is 'drained' (grounding consumed) to GND via the first capacitor C1 and the second capacitor C2, then the noise energy is 'blocked' via the common-mode inductor L, and then the noise energy is 'drained' to GND via the two-stage RC low-pass filter 310 (R1+C5 and R2+C6), so as to realize the reasonably matching of the 'blocking' and 'draining' to solve the noise anti-interference problem of various tests based on a concise protective filtering circuit.

The following is a brief description of the principle that the present disclosure can be compatible with various anti-interference tests:

### 1) In regard to transient high voltage tests such as electrostatic discharge ESD and electrical fast transient EFT.

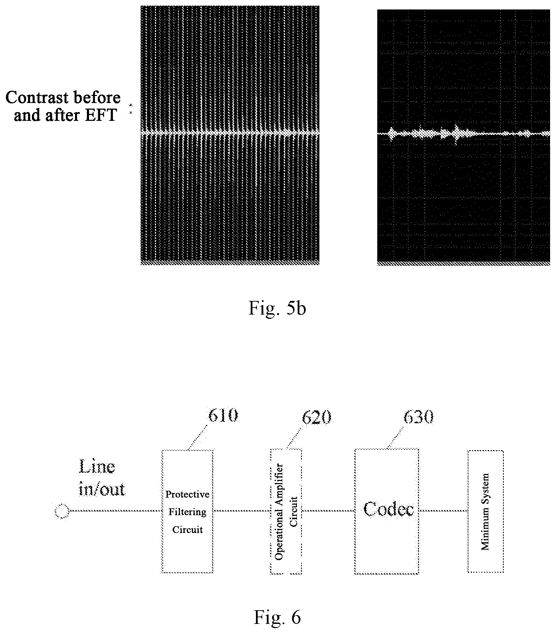

In the present disclosure, the electrostatic voltage in the audio signal is reduced to a preset value by adding a protector TVS, so as to realize overvoltage protection, thus being compatible with transient high voltage tests such as ESD and EFT, as shown in Fig. 5b.

Moreover, in regard to the EFT test, the present disclosure also filters common-mode interference and differential-mode interference by adding the common-mode filtering module 210 and the differential-mode filtering module 220, and then combines the auxiliary filtering of low-pass filter 310 and high-frequency filter, thus being compatible with the EFT test.

### 2) In regard to CS, BCI and RS tests for conducted immunity test system.

Through the low-pass filter 310 and the high-frequency filter, the present disclosure filters the positive waveform noise energy ( such as the sound signals in the white ellipse ② and ③ as shown in Fig. 5a) and retains the normal sound signals (such as the sound signals in the white ellipse ① as shown in Fig. 5a), thus being compatible with CS, BCI and RS tests.

### 3) In regard to SURGE tests for surge immunity

In the present disclosure, the primary voltage reduction treatment is carried out by adding a protector, and the secondary voltage reduction treatment is carried out by the first resistor R1 and the second resistor R2 in the secondary RC filter, thus being compatible with the SURGE tests.

It can be seen that in the present embodiment, by introducing the protector, the common-mode filtering module 210, the differential-mode filtering module 220 and the low-pass filter 310, and reasonably matching the ways of 'blocking' and 'draining' of each part to noise energy, so as to achieve the purpose of solving the problem of noise interference based on a concise protective filtering circuit; moreover, the present embodiment can also realize circuit modularity and strong reusability.

Fig. 6 is a schematic diagram of the structure of an audio processing system provided by another embodiment of the present disclosure. Referring to Fig. 6, the system may specifically include: a protective filtering circuit 610, an operational amplifier circuit 620 and a Codec 630, wherein:
the protective filtering circuit 610 corresponds to the audio processing system provided by the corresponding embodiment in Fig. 1, and the working principle is similar. Therefore, the protective filtering circuit will not be described here.

The operational amplifier circuit 620 is connected to the protective filtering circuit 610, specifically, can be connected to a high-frequency filter in the protective filtering circuit 610, and is configured for restoring the amplitude of the audio signal output by the high-frequency filter.

The Codec 630 is connected to the operational amplifier circuit 620, and is configured for encoding and decoding the audio signal output by the operational amplifier circuit 620 and outputting it to the minimum system.

It should be noted that both the operational amplifier circuit 620 and the Codec 630 need power supply, and when 3.3V or other voltages are externally connected, the power supply may have its own switching noise and couple other noises. Therefore, in order to filter the noise on the power supply and ensure that the analog signal is clean, the present embodiment is equipped with a third filtering device on the basis of the corresponding embodiment in Fig. 1.

Referring to Fig. 2, the third filtering device includes a second magnetic bead FB2, the second magnetic bead FB2 is arranged between the operational amplifier circuit 620 and the power supply of the operational amplifier circuit 620, and is configured for filtering the power supply noise of the power supply of the operational amplifier circuit 620.

The third filtering device further includes a third magnetic bead FB3, the third magnetic bead FB3 is arranged between the Codec 630 and the power supply of the Codec 630, and is configured for filtering the power supply noise of the power supply of the Codec 630.

Wherein, the second magnetic bead FB2 and the third magnetic bead FB3 need to maintain a high impedance, preferably greater than 600 ohms, in the range of 20-3000 MHz, and the inductance X in this frequency band needs to be less than the resistance of the resistor R.

It can be seen that in the present embodiment, the combination of the operational amplifier circuit 620 and the protective filtering circuit 610 solves the problem of partial attenuation of the filtered sound and prevents the original sound signal from being damaged or attenuated. Moreover, a third filtering device is arranged between the operational amplifier circuit 620, the Codec 630 and a power supply thereof, so as to filter the noise existing on the power supply and further improve the audio anti-interference capability.

In addition, it is not difficult to understand that the parameters of each device of the circuit in the above embodiments are examples, and the specific parameter values may be determined according to the specific requirements.

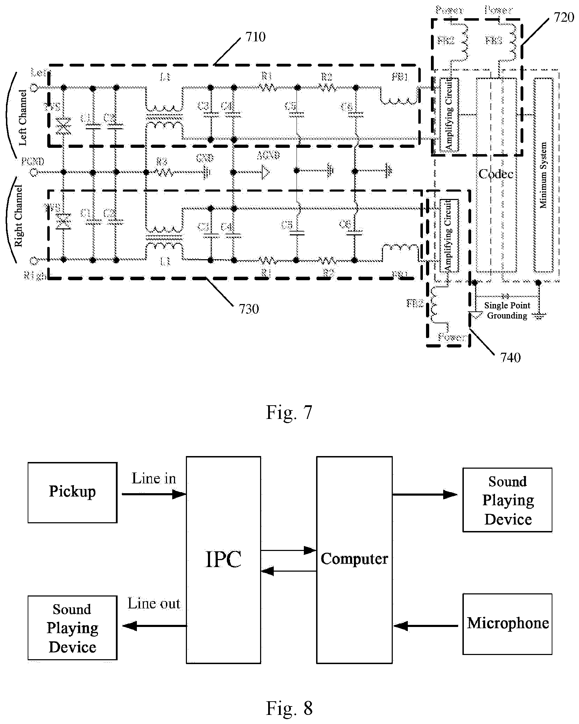

Fig. 7 is a schematic diagram of the structure of an audio processing system provided by another embodiment of the present disclosure. Referring to Fig. 7, the system includes: a left channel subsystem and a right channel subsystem of the system as described above, wherein:
the left channel subsystem includes a first module 710 and a second module 720. The first module 710 is similar to a combination of the protective device 100, the first filtering device 200 and the second filtering device 300 in the audio processing system shown in Fig. 1, and the second module 720 is similar to a combination of the amplifying circuit and the third filtering device in the audio processing system shown in Fig. 2.

The right channel subsystem includes a third module 730 and a fourth module 740. The third module 730 is similar to a combination of the protective device 100, the first filtering device 200 and the second filtering device 300 in the audio processing system shown in Fig. 1, and the fourth module 740 is similar to a combination of the amplifying circuit and the second magnetic bead FB2 in the audio processing system shown in Fig. 2.

The difference between the present embodiment and the monophonic audio processing system provided by the corresponding embodiment in Fig. 2 is that in the present embodiment, the circuits of the left channel subsystem and the right channel subsystem are rearranged, including that:
the TVS of the left channel subsystem and the TVS of the right channel subsystem have a common end and are grounded.

The first capacitor C1 and the second capacitor C2 of the left channel subsystem and the first capacitor C1 and the second capacitor C2 of the right channel subsystem share the same resistor R3 for grounding, and the resistance value of the resistor R3 can be determined according to requirements. Of course, the first capacitor C1 and the second capacitor C2 of the left channel subsystem and the first capacitor C1 and the second capacitor C2 of the right channel subsystem can also be respectively connected to a resistor for grounding, which is not limited here.

The fourth capacitor C4 of the left channel subsystem and the fourth capacitor C4 of the right channel subsystem are connected to the same secondary ground AGND. Of course, the fourth capacitor C4 of the left channel subsystem and the fourth capacitor C4 of the right channel subsystem can also be connected to a secondary ground AGND respectively, which is not limited here.

The fifth capacitor C5 of the left channel subsystem and the fifth capacitor C5 of the right channel subsystem have a common end and are grounded, and the sixth capacitor C6 of the left channel subsystem and the sixth capacitor C6 of the right channel subsystem have a common end and are grounded.

Based on this, the present embodiment can solve the compatibility problem of noise anti-interference in various tests of dual channels, in addition, based on circuit rearrangement, the simplicity of circuit layout is improved, and circuit modularity and strong reusability are realized.

Fig. 8 is a schematic diagram of the structure of a network camera IPC provided by an embodiment of the present disclosure. Referring to Fig. 8, the network camera may specifically include: an audio input and output device, an audio processing system and a Codec, wherein:
in Line in mode of IPC:
the audio input and output device inputs the audio signals acquired by sound acquisition devices such as pickups into the audio processing system, which processes the audio signals based on the audio processing process of the audio processing system shown in the corresponding embodiment of Fig. 2 or Fig. 7, and sends the processed audio signals to the Codec 630, which encodes and decodes the audio signals output by the audio processing system and transmits it to an external equipment such as computers via the network for playback by the computer via a sound playing device.

### In Line out mode of IPC:

An external equipment such as a computer collects the audio signal via a microphone and sends it to the Codec 630 of IPC. The Codec 630 performs encoding and decoding processing and inputs it to the audio processing system, which processes the audio signals based on the audio processing process of the audio processing system given in the corresponding embodiment of Fig. 2 or Fig.7, and sends the processed audio signals to the audio input and output device, which sends the audio signals to a sound playing device.

Based on this, the network camera provided by the embodiment can solve the compatibility problem of noise anti-interference in various tests.

Specific embodiments of the present disclosure are described above. Other embodiments are within the scope of the appended claims. In some cases, the actions or steps recited in the claims may be performed in a sequence different from that in the embodiments and still achieve the desired results. In addition, the processes depicted in the drawings do not necessarily require the specific sequence or the continuous sequence shown to achieve the desired results. In some embodiments, multitasking and parallel processing are also possible or may be advantageous.

It should be understood by those skilled in the art that embodiments of the present disclosure may be provided as a method, a system, or a computer program product. Therefore, the present disclosure can take the form of a complete hardware embodiment, a complete software embodiment, or an embodiment combining software and hardware aspects. Furthermore, the present disclosure may take the form of a computer program product embodied on one or more computer usable storage media (including but not limited to disk storage, CD-ROM, optical storage, etc.) in which computer usable program codes are embodied.

The present disclosure is described with reference to the flow chart and/or block diagrams of the method, equipment (system), and computer program product according to the embodiment of the present disclosure. It should be understood that each flow and/or block in the flowchart and/or block diagram, and combinations of the flow and/or block in the flow chart and/or block diagram can be implemented by computer program instructions. These computer program instructions may be provided to the processor of a general-purpose computer, a special-purpose computer, an embedded processor or other programmable data processing equipment to produce a machine, such that the instructions which are executed by the processor of the computer or other programmable data processing equipment produce device for implementing the functions specified in flow or flows in the flowchart and/or block or blocks in the block diagram.

These computer program instructions may also be stored in a computer-readable memory that can guide the computer or other programmable data processing equipment to work in a particular way, such that the instructions stored in the computer-readable memory produce a manufacturing product including an instruction device that implement the functions specified in flow or flows in the flowchart and/or block or blocks in the block diagram.

These computer program instructions may also be loaded onto a computer or other programmable data processing equipment, such that a series of operational steps are executed on the computer or other programmable equipment to produce computer-implemented processing, such that the instructions executed on the computer or other programmable equipment provide steps for implementing the functions specified in flow or flows in the flowchart and/or block or blocks in the block diagram.

In a typical configuration, a computing equipment includes one or more processors (CPU), input and output interfaces, network interfaces, and memory.

Memory may include non-permanent memory, random access memory (RAM) and/or non-volatile memory in computer-readable media, such as read-only memory (ROM) or flash memory. Memory is an example of a computer-readable medium.

Computer-readable media including permanent and non-permanent, removable and non-removable media can be used by any method or technology to implement information storage. Information can be computer-readable instructions, data structures, modules of programs or other data. Examples of storage media for computers include, but not limited to: phase change memory (PRAM), static random access memory (SRAM), dynamic random access memory (DRAM), other types of random access memory (RAM), read-only memory (ROM), electrically erasable programmable read-only memory (EEPROM), flash memory or other memory technologies, compact disc read-only memory (CD-ROM), and digital versatile disc (DVD) or other optical storage, magnetic cartridge tape, magnetic disk storage or other magnetic storage devices or any other non-transport medium that can be used to store information that can be stored by a computer. According to the definition herein, computer-readable media does not include transient computer-readable media (transitory media), such as modulated data signals and carrier waves.

It should also be noted that the terms "including", "comprising" or any other variation thereof are intended to cover non-exclusive inclusion, so that a process, method, commodity or equipment including a series of elements includes not only those elements, but also other elements not explicitly listed, or elements inherent in such process, method, commodity or equipment. In the absence of further restrictions, an element defined by the phrase "including a" does not exclude the existence of other identical elements in the process, method, commodity or equipment including the element.

It should be understood by those skilled in the art that embodiments of the present disclosure may be provided as a method, a system, or a computer program product. Therefore, the present disclosure can take the form of an complete hardware embodiment, an complete software embodiment, or an embodiment combining software and hardware aspects. Furthermore, the present disclosure may take the form of a computer program product embodied on one or more computer usable storage media (including but not limited to disk storage, CD-ROM, optical storage, etc.) in which computer usable program codes are embodied.

The above is only an embodiment of the present disclosure, and is not intended to limit the present disclosure. For those skilled in the art, the present disclosure may have various modifications and variations. Any modification, equivalent replacement, improvement, etc. made within the spirit and principle of the present disclosure should be included in the scope of the claims of the present disclosure.

## Claims

1. An audio processing system, comprising: a protective device (100), a first filtering device (200) and a second filtering device (300) connected in sequence, wherein:
the protective device (100) comprises a protector connected to an audio input and output device and configured for reducing an electrostatic voltage in an inputted or outputted audio signal to a preset value;
the first filtering device (200) comprises a common-mode filtering module (210) and a differential-mode filtering module (220), wherein the common-mode filtering module (210) is connected to the protector and is configured for consuming a noise energy in the audio signal and filtering a common-mode interference; the differential-mode filtering module (220) is connected to the common-mode filtering module (210) and is configured for filtering a differential-mode interference;
the second filtering device (300) comprises a low-pass filter (310), which is connected to the differential-mode filtering module (220) and configured for high-frequency noise filtering of the audio signal.

2. The system according to claim 1, wherein the protector comprises a transient suppressor, one end of the transient suppressor is connected to a positive terminal of the audio input and output device, and the other end of the transient suppressor is connected to a negative terminal of the audio input and output device.

3. The system according to claim 1, wherein the common-mode filtering module (210) comprises a first capacitor (C1), a second capacitor (C2) and a common-mode inductor (L), wherein:
the first capacitor (C1) and the second capacitor (C2) are sequentially connected in parallel with the protector and grounded through a resistor for consuming the noise energy in the audio signal;
the common-mode inductor (L) is arranged between the second capacitor (C2) and the differential-mode filtering module (220) for filtering the common-mode interference.

4. The system according to claim 3, wherein the differential-mode filtering module (220) comprises a third capacitor (C3) and a fourth capacitor (C4), wherein:
the third capacitor (C3) and the fourth capacitor (C4) are sequentially connected to the common-mode filtering module (210) and grounded for filtering the differential-mode interference.

5. The system according to claim 4, wherein the first capacitor (C1) and the second capacitor (C2) are connected to a primary ground, GND, and the third capacitor (C3) and the fourth capacitor (C4) are connected to a secondary ground, AGND.

6. The system according to claim 1, wherein the low-pass filter (310) comprises a first resistor (R1), a fifth capacitor (C5), a second resistor (R2) and a sixth capacitor (C6), wherein:
one end of the first resistor (R1) is connected to the differential-mode filtering module (220), and the other end of the first resistor (R1) is connected to one end of the fifth capacitor (C5), and the other end of the fifth capacitor (C5) is grounded;
one end of the second capacitor (C2) is connected to a common end of the first resistor (R1) and the fifth capacitor (C5), and the other end of the second capacitor (C2) is connected to one end of the sixth capacitor (C6), and the other end of the sixth capacitor (C6) is grounded.

7. The system according to claim 1, wherein the second filtering device (300) further comprises: a high-frequency filter;
the high-frequency filter comprises a first magnetic bead (FB1) connected to the low-pass filter (310) and configured for secondary high-frequency noise filtering of the audio signal, and a noise frequency filtered by the high-frequency filter is greater than a noise frequency filtered by the low-pass filter (310).

8. The system according to claim 7, further comprising: a third filtering device;
wherein the third filtering device comprises a second magnetic bead (FB2), the second magnetic bead (FB2) is arranged between an operational amplifier circuit (620) and a power supply of the operational amplifier circuit (620) and configured for filtering a power supply noise;
wherein, the operational amplifier circuit (620) is connected to the high-frequency filter for restoring an amplitude of an audio signal outputted by the high-frequency filter.

9. The system according to claim 8, wherein the third filtering device further comprises a third magnetic bead (FB3), which is arranged between a Codec (630) and a power supply of the Codec (630) and configured for filtering the power supply noise;
wherein, the Codec (630) is connected to the operational amplifier circuit (620) for processing an audio signal output by the operational amplifier circuit (620).

10. An audio processing system, comprising: a left channel subsystem and a right channel subsystem of the system according to any one of claims 1 to 9.

11. A network camera, comprising: an audio input and output device, an audio processing system according to any one of claims 1 to 9, and a Codec (630), wherein:
the audio input and output device is configured for inputting an audio signal acquired by a sound acquisition device to the audio processing system, or, outputting an audio signal outputted by the audio processing system to a sound playing device;
the Codec (630) is configured for encoding and decoding the audio signal outputted by the audio processing system and transmitting the audio signal to an external equipment via a network; or, encoding and decoding an audio signal inputted by the external equipment and inputting the audio signal to the audio processing system.
